# EUROPEAN PATENT APPLICATION

(11) **EP 2 055 804 A1**
(43) Date of publication of application: **06.05.2009**
(21) Application number: 07119491.4
(22) Date of filing: 29.10.2007
(51) Int. Cl.: C23C 16/448, C25B 9/10, C25B 9/04

(54) **Method for preparing a deposition from a vapour**

(71) Applicant: Nederlandse Organisatie voor Toegepast- Natuurwetenschappelijk Onderzoek TNO, 2628 VK Delft (NL)
(72) Inventor: The designation of the inventor has not yet been filed
(74) Representative: Hatzmann, Martin

(57) **Abstract**

The invention is directed to a method for preparing a deposition on a substrate and to a method for manufacturing an electronic or optoelectronic device.

The method of the invention comprises
- providing an ionic liquid comprising a precursor material for the deposition
- vaporising the precursor material from the ionic liquid; and
- depositing the precursor material on the substrate.

## Description

The invention is directed to a method for preparing a deposition on a substrate and to a method for manufacturing an electronic or optoelectronic device.

In the art, a number of techniques are available for producing high-purity, high-performance thin films of a material onto a substrate. These techniques include vapour deposition techniques in which a material in the vapour state is adsorbed onto a substrate. Vapour deposition techniques are for instance used in the electronics and optoelectronics industries.

In a physical vapour deposition process a precursor material (such as metal, alloy, cermet, or composite) is deposited onto a substrate by physical means, such as evaporation or sputtering. In a chemical vapour deposition process the deposition is the result of thermochemical vapour-phase reactions. A special form of chemical vapour deposition is atomic layer deposition according to which different reactants are brought to the substrate sequentially, preferable with "dead" times in between. Atomic layer deposition makes use of the fact that the incoming material is bound strongly until all sites available for chemisorption are occupied. The dead times are used to flush the excess material, before the other reactant is presented to the substrate.

For some applications it is necessary to control the composition and thickness of the resulting layers. This in turn requires accurate control of the amounts of precursor vapours entering the vapour deposition reactor. Controlling of the dosing of precursor vapours normally depends upon the physical state of the precursor at ambient temperature and one atmosphere pressure. For example, in the case of gas precursors the dosimetry into the reactor is usually controlled using a calibrated mass-flow controller. In contrast, solid and liquid precursors are usually placed in a vessel with an inlet and an outlet such that well known carrier gases can be passed through the vessel, thereby entraining the precursor vapours away for conduction to the reactor.

Typical vessels are known as "bubblers", see for instance WO-A-93/03196. These vessels are equipped with an inlet tube, which conducts carrier gas to the bottom of the precursor sample, and an outlet which opens directly from the top of the vessel. The carrier gas is thereby passed through the precursor sample and therefore entrains some of the precursor vapour before being forced out of the bubbler at the top.

A bubbler arrangement to control the dosimetry of precursors into a vapour deposition reactor requires accurate control of the flow of carrier gas through the bubbler in addition to reliable efficiency of entrainment of the precursor vapours in the carrier gas. Control of the carrier gas flow is normally achieved using a mass-flow controller. The efficiency of entrainment of precursor vapours, however, depends upon the condensed phase, as well as the actual evaporation coefficient α of the condensed phase itself.

A conventional way to obtain reproducible dosimetry from a conventional bubbler is to ensure that the carrier gas is saturated with the precursor vapour. The saturated vapour pressure of a material is fixed for a given temperature, so if it can be ensured that the carrier gas is saturated then the concentration of precursor therein will always be the same. Liquid precursors indeed readily approach saturation to the extent that the dosimetry from a conventional bubbler is reproducible until the vessel is virtually empty; at least while the carrier gas still bubbles through the precursor.

However, for solid precursors the pick-up from the bubble is notoriously unreliable. Frequently, the carrier gas must be passed through the bubbler for a considerable time before the concentration of precursor in the outlet gas is stable. Moreover the final concentration attained has been observed to fluctuate throughout the usage of the source. This fluctuation may be either an increase or decrease in the efficiency of pick-up, and may be either a gradual or abrupt change. The fluctuations are the result of processes such as the regrowth of crystals, the migration of precursor material because of temperature gradients within the bubbler vessel, the formation of channels within the precursor material, the contamination of the surface of the sample by traces of impurities and/or precursor structure varieties such as metastables.

Further, during the production of small amounts of vapour flow from solid precursor in a bubbler, the precursor is subjected to a high temperature, for a relatively long time, which can be destructive to the precursor material.. The extent to which exposure to a high temperatures has a destructive effect on the precursor strongly depends on the precursor material used and the exposure time. For example, US-A-2006/0 264 061 describes that, when using the solid precursor source of pentakisdimethyl tantalum Ta(NMe₂)F₅, the solid-state evaporation temperature is less than approximately 90 °C, and the melting point is approximately 180 °C or greater. The thermal decomposition of Ta(NMe₂)F₅ is based on both temperature and time. Ta(NMe₂)F₅ decomposes for 3 % at a temperature greater than 90 °C when heated approximately 6 hours.

There is a strong need for an efficient precursor delivery system that can deliver a large vapour flow of precursor material to vapour deposition processes, wherein the vapour flow is stable in its composition and flux. At present, the use of solid precursors involves huge difficulties, such as decomposing of the precursors, sintering, etc. In conventional bubblers, the sublimation of solid precursors is accompanied with a number of intrinsic problems.

When a molecule leaves the surface of a solid precursor, it leaves behind a highly reactive site (e.g. a free orbital) that can have a tendency to sinter or to react with neighbouring bonds or with molecules in the vapour phase. The sintering process is not yet fully understood. Without being bound by theory, it is believed to be related with the surface tension. Sublimation is a dynamic process of continuous adsorption and desorption of molecules. Some compounds form a powder with a large surface area that condenses into a large aggregate of precursor with a small surface area. The small surface area decreases the rate of desorption, and thereby the amount of material sublimated. As a result of this process, the form and morphology of the solid precursor can change and the sublimation rate can vary during the process.

Furthermore, the use of a carrier gas (which is necessary for the conventional methods of solid precursor delivery) is accompanied with disadvantages with respect to control of the vapour flow and can perturb the vapour deposition process.

Due to the above-mentioned phenomena, an accurate control of the sublimation of solid precursors is difficult to achieve. A weak control over the sublimation process leads to a weak control over the corresponding deposition process, which makes the growth rate of thin layers unpredictable.

Object of the invention is therefore to provide an improved vapour deposition method, which solves at least one of the problems encountered with in conventional vapour deposition techniques.

A further object of the invention is to provide a vapour deposition method that can be accurately and preferably easily controlled.

A further object of the invention is to provide a vapour deposition method that does not require the use of a carrier gas.

The inventors surprisingly found that one or more of these objects can be met by applying an ionic liquid.

Accordingly, in a first aspect, the invention is directed to a method for preparing a deposition on a substrate comprising
- providing an ionic liquid comprising a precursor material for the deposition
- vaporising the precursor material from the ionic liquid; and
- depositing the precursor material on the substrate.

Surprisingly, the inventors found that the ionic liquid does not, or not noticeably, evaporate or decompose when vaporising the precursor material from the ionic liquid.

The inventors have realised that ionic liquids generally have an extremely low vapour pressure at temperatures below their decomposition temperature, in particular with respect to the precursors to be vaporised. Thus, the inventors have come to the conclusion that vapours of the ionic liquid that could interfere with the deposition process do not or scarcely end up in the deposition process. Furthermore, since the ionic liquid is not readily vaporised, the loss of ionic liquid is extremely low. Hence, there is no, or hardly any, consumption of the ionic liquid during the process.

The term "precursor material" in this application is meant to refer to material to be deposited. The term includes material part of which is to be deposited. Thus, a material which is dissociated into an anion and a cation, of which the cation forms a new molecule to be deposited, is also considered a precursor material in this application.

In principle, unless an impurity has an extremely low vapour pressure, impurities are at least substantially removed from the ionic liquid. Extremely low impurity content is desirable, because impurities may have a negative influence on the performance of the ultimate product.

After the vaporisation process it is possible to regenerate the ionic liquid. Depending on the type and morphology of the impurities, remaining impurities can be separated from the ionic liquid by means of separation technologies, such as extraction filtration, membrane filtration, or crystallisation. The ionic liquid can then be reused. A further advantage of using an ionic liquid is that the heat transfer of an ionic liquid is much more efficient in comparison with a solid material or powder. Accordingly, subliming the precursor material from an ionic liquid costs less energy than conventional sublimation processes.

The precursor can be dissolved, dispersed or suspended in the ionic liquid, as long as the precursor is homogeneously distributed therein. Because the precursor material is comprised in the ionic liquid and is vaporised from the ionic liquid, it is relatively easy to control the flux of vaporised precursor material in comparison to conventional techniques.

In the method of the invention physical vapour deposition, chemical vapour deposition and/or atomic layer deposition can be used.

The term "ionic liquid" in this application is meant to refer to molten salts, in particular salts that are liquid under the process and storage conditions. Preferably the ionic liquids are liquid at least at room temperature. This makes the ionic liquid easy to handle. More preferably the ionic liquids are liquid at a temperature of less than -10 °C. This is convenient for storage and transportation.

The cations of the ionic liquid can for instance be selected from the group consisting of monosubstitued imidazolium, disubstituted imidazolium, trisubstituted imidazolium, pyridinium, pyrrolidinium, phosphonium, ammonium, guanidinium, tri-substituteted sulphonium and isouronium, or derivatives thereof.

The anions of the ionic liquid can for instance be selected from the group consisting of chloride, bromide, iodide, nitrate, nitrite, fluoride, phosphate, imide, amide, borate, tosylate, tetrafluoroborate, hexafluoroborate, hexafluorophosphate, trifluoromethanesulphonate, methylsulphate, bis(pentafluoroethyl)phosphinate, thiocynate, octylsulphate, hexylsulphate, butylsulphate, ethylsulphate, dicyanamide, hexafluoroantimonate, bis-(pentafluoroethyl)phosphinate, bis-(trifluoromethyl)imide, trifluoroacetate, bis-trifluorosulphonimide, and dicyanamide.

Other ionic liquids that can be used in the method of the invention are salts formed by the reaction of at least one amine salt of the formula R¹R²R³R⁴N⁺X⁻ (I) with at least one hydrated salt, which is a chloride, nitrate, sulphate or acetate of Li, Mg, Ca, Cr, Mn, Fe, Co, Ni, Cu, Zn, Cd, Pb, Bi, La or Ce; wherein R¹, R² and R³ are each independently a C₁-C₅ alkyl or a C₆-C₁₀ cycloalkyl group, or wherein R² and R³ taken together represent a C₄-C₁₀ alkylene group, thereby forming with the N atom of formula (I) a 5 to 11 membered heterocyclic ring, and wherein R⁴ is hydrogen, or phenyl, or a C₁-C₁₂ alkyl or cycloalkyl group, optionally substituted with at least one group selected from -OH, -Cl, -Br, -F, -I, -phenyl, -NH₂, -CN, -NO₂, -COOR⁵, -CHO, -COR⁵ and -OR⁵, wherein R⁵ is a C₁-C₁₀ alkyl or cycloalkyl group; and X⁻ is an anion capable of being complexed by said hydrated salt.

A wide variety of precursor materials can be used in the method of the invention. The invention is particularly suitable for precursor materials that are solid at room temperature. Examples are metals (such as Hf, Zr, Ti, Al, Cu, Mo, Ta, W, Pd, Pt, Au, Ru, and In), metal-organic compounds (such as trimethyl indium, triphenyl aluminium, triphenyl bismuth, tert-butyl lithium, tritolyl bismuth, cyclopentadienyl lithium, cyclopentadienyl magnesium, cyclopentadienyl manganese, barium acetylacetonate complex, strontium acetylacetonate complex, copper acetylacetonate complex, yttrium acetylacetonate complex, calcium acetylacetonate complex, barium dipivaloylmethanate, strontium dipivaloylmethanate, copper dipivaloylmethanate, yttrium dipivaloylmethanate, calcium dipivaloylmethanate), metal halides (such as hafnium tetrachloride, zirconium tetrachloride, aluminium trichloride, molybdenum pentachloride, tantalum pentachloride, titanium pentachloride, and tungsten hexafluoride), metalloids (such as B, Si, Ge, As, Sb, Te, and Po), metalloid-organic compounds (such as tetraethylorthosilicate), metalloid halides (such as silicon tetrachloride), inorganic compounds (such as trioxochromium), and vaporisable polymers.

Also suitable as a precursor material is a precursor material selected from the group of organometal compounds comprising a covalent metal-carbon bond, metal-organic compounds comprising a covalent metal-oxygen bond, and coordination compounds wherein the metal is not covalently bound to the organic compound. Examples of such compounds include metal alkyls (such as (CH₃)₃In and ferrocene), metal alkylamides (such as Ta(N(CH₃)₂)₅, metal carbonyls (such as Cr(CO)₆ and W(CO)₆), metal alkoxides (such as Ta(OCH₃)₅), metal β-diketonates (such as Ba(2,2,6,6-tetramethyl-3,5-heptanedione)₂ and Cu(2,2,6,6-tetramethyl-3,5-heptanadione)₂) and compounds such as cyclopentadienyl-triethylphosphine-copper.

Preferably, the precursor material at least partly evaporates at a temperature below the dissociation or boiling point of the ionic liquid.

Preferred precursor materials are metal halides and metalloid halides, more particularly metal halides and metalloid halides. More preferred are metal chlorides and metalloid chlorides.

A particularly preferred precursor material is Hf, for depositing HfO₂. Hafniumoxide has a high dielectric constant and is therefore suitable for the replacement of the classical silicon dioxide in metal-oxide-semiconductor field-effect transistor gates. Hf can be deposited from the precursor tetrakis(ethyl methyl amido)hafnium, also known as TEMAH, because in this form it is liquid. However, this precursor has the disadvantage that the organic carbon chain also ends up in the deposition reactor and negatively influences the produced layer. The invention also allows depositing Hf using another precursor, such as Hf tetrachloride.

The amount of precursor material in the ionic liquid can vary. The ionic liquid can for instance comprise 0.1-70 mol% of the precursor material, preferably 10-70 mol% of the precursor material, more preferably 40-70 mol% of the precursor material, based on the total weight of the ionic liquid. It is preferred to have a high precursor concentration. When the precursor concentration is high less ionic liquid is required for the deposition. Accordingly, also less ionic liquid needs to be stored.

Normally, the vapour deposition is carried out at low pressure (vacuum) or even very low pressure (ultrahigh vacuum). However, vapour deposition can also be carried out at atmospheric pressure. Reduced pressures tend to reduce unwanted gas-phase reactions and improve the film uniformity across the substrate. The pressure in the deposition reactor can be below 100 mbar, preferably below 10 mbar, more preferably below 1 mbar, or even below 0.1 mbar. Preferably, the pressure in the deposition reactor is 0.1-10 mbar.

According to a preferred embodiment of the invention the precursor is provided in an electrochemical fashion. To this end an anode, which comprises an electrolytically ionisable material, and a cathode can be contacted with the ionic liquid. The electrode can for instance be composed of precursor material, or precursor material can be present as a layer on the electrode. The ionic liquid may comprise anions that are capable of forming a molecule with the electrolytically ionised material. The ionisable material is then electrolytically oxidised under formation of cations that dissolve in the ionic liquid. In case suitable anions are present, the cations may form molecules with anions in the ionic liquid. The cations, or the molecules formed with the anions, are then evaporated from the ionic liquid and may subsequently be deposited on the substrate.

An electrode can be used as a source for the electrolytically ionisable precursor material. The electrode can for instance be composed of the precursor material, or the precursor material can be present as a layer on the electrode. The advantage of using an electrode for supplying the precursor material is that it is easy to handle. The use of an electrode has the additional advantage that dosimetry can be readily controlled by adjusting the electrical current or voltage of the electrode. Another advantage is that the electrode can at the same time be used as a heat source in order to evaporate the cation or salt from the ionic liquid. Furthermore, the invention directly provides high purity of the synthesised precursor without the need for separate purification steps, whereas precursors such as TEMAH or HfCl₄ require a number of purification steps.

When the electrodes are connected through a source of current the anode will become positively charged and the cathode will become negatively charged. Electrons from the electrolytically ionisable material migrate into the anode and through the external electrical circuit to the cathode. The electrolytically ionisable material thereby becomes positively charged and dissolves in the ionic liquid.

In this embodiment, the anode preferably comprises at least one element selected from the group consisting of metals and metalloids, more preferably at least one element selected from the group consisting of Hf, Zr, Ti, Al, Cu, Mo, Ta, W, Ru, Si, Ge, Ba, Ca, Sr, Co, Mg, Sn, Pd, Pt, Au and As.

In addition, the ionic liquid preferably comprises anions that are capable of forming molecules with the electrolytically ionised material. These anions may be comprised in the ionic liquid, but can also stem from an additionally provided salt. Such anions are preferably halogen ions, preferably chloride, bromide or iodide. The concentration of additional anions in the electrically conductive liquid not comprised in the ionic liquid is preferably low, such as 0.1 M or less, preferably 0.001-0.01 M.

Advantageously, the concentration of the cations in the ionic liquid can be regulated by controlling the electrical current through the anode. To this end a sensor can be provided for measuring the concentration of the cations or the molecules formed from the cation and the anion in the vapour from the liquid. The electrical current can then be adjusted or controlled as a result of that measurement. This allows a highly stable vapour flow of material to be deposited.

A carrier gas, such as H₂, N₂, Ne, He or Ar, can be applied to assist the transport of the evaporated precursors to the deposition reactors.

In a special embodiment of the invention, the precursor is evaporated using film evaporation (*e*.*g*. using a spinning disc) or a membrane module. In case high temperatures, such as temperature of 80 °C or more, are required for vaporising the precursor material a ceramic membrane module can be applied. According to this embodiment an ionic liquid with the precursor comprised therein is transported through a membrane at the desired temperature. The precursor can then evaporate from the ionic liquid through the pores of the membrane. The advantage thereof is that the membrane creates a huge evaporation surface. A hollow fibre membrane is more suitable than a flat membrane for this purpose, because it has a larger area per volume).

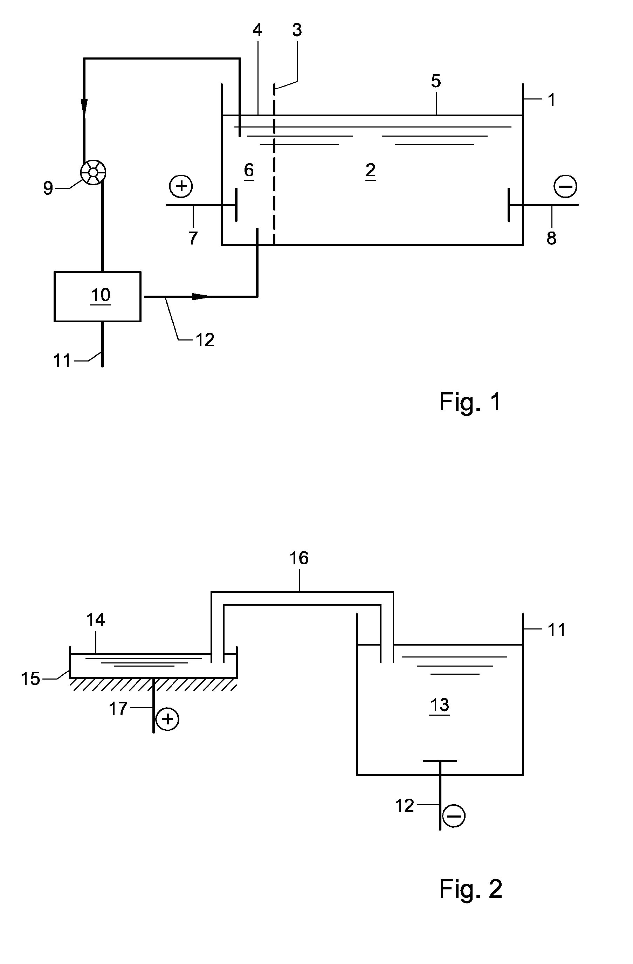

An advantageous embodiment for carrying out the process of the invention is shown in Figure 1. Container 1 comprises an electrolyte 2 and an ion selective membrane 3, which divides the container into compartments 4 and 5, respectively. Preferably compartment 4 is significantly smaller than compartment 5. Both compartments comprise electrolyte 2. Selective membrane 3 is not permeable for ionic liquid 6, which is maintained in compartment 4. An anode 7 is provided in compartment 4, while cathode 8 is provided in compartment 5. Both anode 7 and cathode 8 are in electrical contact with electrolyte 2. Anode 7 and cathode 8 are connected through an external circuit (not shown) with a source of current. In the embodiment shown in Figure 1, the anode is separate from the container, but it is also possible that a wall of the container serves as the anode. The anode advantageously comprises electrolytically ionisable material. Upon applying a current electrolytically ionisable material from the anode dissolves into ionic liquid 6 in the form of cations, where these dissolved cations can optionally form precursor molecules with anions comprised in compartment 4. In the embodiment shown in Figure 1, the liquid contained in compartment 4 is transported with pump 9 to film evaporator 10. Film evaporator 10 produces a gaseous precursor molecule stream 11 and a liquid stream 12, which is depleted in precursor molecules. Liquid stream 12 can advantageously be recycled into compartment 4. Alternatively, the precursor molecules can directly be evaporated from compartment 4, without using the film evaporator cycle. The advantage of this embodiment is that only a small amount of ionic liquid is required.

In a further embodiment shown in Figure 2, a container 11 is provided, which comprises cathode 12 in electrical contact with electrolyte 13. Electrolyte 13 is connected to ionic liquid 14 contained in a second container 15 through salt bridge 16. Container 15 preferably has a large surface area. At least part of the surface of container 15 which is in contact with ionic liquid 14 serves as anode 17. Anode 17 and cathode 12 are connected through an external circuit (not shown) with a source of current. The anode advantageously comprises electrolytically ionisable material. Upon applying a current electrolytically ionisable material from the anode dissolves into ionic liquid 14 in the form of cations, where these dissolved cations can optionally form precursor molecules with anions comprised in ionic liquid 14. By applying heat to container 15 the formed precursor molecules can be evaporated. Advantages of this embodiment are that only a small amount of ionic liquid is required, that the equipment is simple and that no separate loop is required for efficiently evaporating the precursor material, because container 15 serves as a film evaporator.

The substrate on which the precursor material is deposited can be for instance Si (including coated Si), a metal (such as stainless steel), a ceramic, glass or a polymer.

The method of the invention allows the preparation of very thin layers. In the case of atomic layer deposition layers with an average layer thickness of 10 Å or less per cycle can be prepared. The average layer thickness can be as low as 0.1 Å. The average thickness of the deposited layer in the case of atomic layer deposition is usually in the range of 1-5 Å per cycle. By depositing multiple cycles it is possible to deposit layers having an average layer thickness in the range of 0.01 nm-3 mm, in particular in the range of 0.1 nm-10 µm, more in particular in the range of 0.1 nm-100 nm, and even more in particular in the range of 0.1 nm-50 nm or 0.1 nm-10 nm. The average layer thickness can be determined indirectly using step profilometry and dividing the thickness by the number of atomic layer deposition cycles.

The method of the invention is particularly useful in the semiconductor industry, but also for the glass industry and for making hard coatings (such as Al₂O₃ coatings from AlCl₃ solid precursors), *etc*. Specific examples include coatings on glass for solar cell applications, anti-reflection coatings, low-emissive coatings, hard coatings on tools for increased durability and lifetime, low-ε coatings, and metallisation coatings. Specific products for which the method of the invention may be applied include tools, glass windows, photovoltaics, light emitting diodes (such as organic light emitting diodes), and integrated circuits.

In a further aspect the invention is directed to an apparatus for evaporating a compound, comprising
- a container comprising an ion selective membrane dividing said container in a first compartment for holding an electrolyte and a second compartment for holding an ionic liquid comprising said compound, wherein said first compartment comprises a cathode and said second compartment comprises an anode;
- a conduit for allowing said ionic liquid comprising said compound to be transported from said second compartment to a film evaporator; and
- a conduit for allowing said ionic liquid to be transported from said film evaporator to said second compartment.At least during use of the apparatus, the cathode and anode are electrically connected through an external circuit comprising a power supply.
   In a further aspect the invention is directed to an apparatus for evaporating a compound, comprising
- a first container for holding an electrolyte, wherein said first container comprises a cathode; and
- a salt bridge for allowing ions from said electrolyte to be transported from said container to a film evaporator in the form of a second container for holding an ionic liquid, wherein said film evaporator comprises an anode.

Also according to this aspect, the cathode and anode are electrically connected through an external circuit comprising a power supply, at least during use.

## Claims

1. Method for preparing a deposition on a substrate comprising
- providing an ionic liquid comprising a precursor material for the deposition
- vaporising the precursor material from the ionic liquid; and
- depositing the precursor material on the substrate.

2. Method according to claim 1, wherein chemical vapour deposition, atomic layer deposition or physical vapour deposition is used.

3. Method according to claim 1 or 2, wherein the precursor material is selected from the group consisting of metals, metal-organic compounds, organo-metallic compounds, metal halides, metalloids, metalloid-organic compounds, metalloid halides, and vaporisable polymers.

4. Method according to claim 3, wherein the precursor material comprises an inorganic metal salt or an inorganic metalloid salt, preferably a halide salt, in particular a chloride salt.

5. Method according to any of the preceding claims, wherein the ionic liquid comprises a salt, liquid under the process conditions, selected from salts formed of
- at least one of the cations selected from the group consisting of monosubstitued imidazolium, disubstituted imidazolium, trisubstituted imidazolium, pyridinium, pyrrolidinium, phosphonium, ammonium, guanidinium, tri-substituteted sulphonium and isouronium, or derivatives thereof.
- and at least one of the anions selected from the group consisting of chloride, bromide, iodide, nitrate, nitrite, fluoride, phosphate, imide, amide, borate, tosylate, tetrafluoroborate, hexafluoroborate, hexafluorophosphate, trifluoromethanesulphonate, methylsulphate, bis(pentafluoroethyl)phosphinate, thiocynate, octylsulphate, hexylsulphate, butylsulphate, ethylsulphate, dicyanamide, hexafluoroantimonate, bis-(pentafluoroethyl)phospinate, bis-(trifluoromethyl)imide, trifluoroacetate, bis-trifluorosulphonimide, and dicyanamide.

6. Method according to any of the preceding claims, wherein the ionic liquid comprises a salt, liquid under the process conditions, selected from salts formed by the reaction of at least one amine salt of the formula R¹R²R³R⁴N⁺X⁻ (I) with at least one hydrated salt, which is a chloride, nitrate, sulphate or acetate of Li, Mg, Ca, Cr, Mn, Fe, Co, Ni, Cu, Zn, Cd, Pb, Bi, La or Ce; wherein R¹, R² and R³ are each independently a C₁-C₅ alkyl or a C₆-C₁₀ cycloalkyl group, or wherein R² and R³ taken together represent a C₄-C₁₀ alkylene group, thereby forming with the N atom of formula (I) a 5 to 11 membered heterocyclic ring, and wherein R⁴ is hydrogen, or phenyl, or a C₁-C₁₂ alkyl or cycloalkyl group, optionally substituted with at least one group selected from -OH, -Cl, -Br, -F, -I, -phenyl, -NH₂, -CN, -NO₂, -COOR⁵, -CHO, -COR⁵ and -OR⁵, wherein R⁵ is a C₁-C₁₀ alkyl or cycloalkyl group; and X⁻ is an anion capable of being complexed by said hydrated salt.

7. Method according to any of the preceding claims, wherein an ionic liquid is provided comprising 0.1-70 mol% of the precursor material, preferably 10-70 mol% of the precursor material, more preferably 40-70 mol% of the precursor material based on the total weight of the ionic liquid.

8. Method according to any of the preceding claims, wherein the precursor is evaporated using film evaporation (*e*.*g*. using a spinning disc) or a membrane module, preferably a ceramic membrane module.

9. Method according to any of the preceding claims, wherein the substrate is selected from the group consisting of silicon-based substrates, ceramic substrates, metallic substrates, glass substrates, and polymer substrates.

10. Method according to claim 9, wherein the substrate is selected from the group consisting of Si, SiO₂, glass, stainless steel, and Al.

11. Method according to any of the preceding claims wherein a layer is deposited having an average layer thickness in the range of 0.01 nm-3 mm, in particular in the range of 0.1 nm-10 µm, more in particular in the range of 0.1 nm-100 nm, and even more in particular in the range of 0.1 nm-10 nm.

12. Method for manufacturing an electronic or optoelectronic device comprising depositing a material by a method according to any of the preceding claims.

13. Use of a film evaporator or a membrane module in a vapour deposition process.

14. Apparatus for evaporating a compound, comprising
- a container comprising an ion selective membrane dividing said container in a first compartment for holding an electrolyte and a second compartment for holding an ionic liquid comprising said compound, wherein said first compartment comprises a cathode and said second compartment comprises an anode;
- a conduit for allowing said ionic liquid comprising said compound to be transported from said second compartment to a film evaporator; and
- a conduit for allowing said ionic liquid to be transported from said film evaporator to said second compartment.

15. Apparatus for evaporating a compound, comprising
- a first container for holding an electrolyte, wherein said first container comprises a cathode; and
- a salt bridge for allowing ions from said electrolyte to be transported from said container to a film evaporator in the form of a second container for holding an ionic liquid, wherein said film evaporator comprises an anode.
